# EUROPÄISCHE PATENTSCHRIFT

(11) **EP 4 406 890 B1**
(45) Veröffentlichungstag und Bekanntmachung des Hinweises auf die Patenterteilung: **27.05.2026**
(21) Anmeldenummer: 23153019.7
(22) Anmeldetag: 24.01.2023
(51) Int. Cl.: B65H 29/54, H01L 23/24, H01L 23/10, B32B 38/18, H01L 23/373

(54) **VORRICHTUNG, ANORDNUNG UND VERFAHREN ZUM AUTOMATISIERTEN ABLÖSEN EINES WÄRMELEITPADS VON EINER TRÄGERFOLIE**
DEVICE, ARRANGEMENT AND METHOD FOR AUTOMATICALLY DETACHING A THERMALLY CONDUCTIVE PAD FROM A CARRIER FILM
DISPOSITIF, AGENCEMENT ET PROCÉDÉ DE DÉTACHEMENT AUTOMATISÉ D'UN COUSSINET THERMOCONDUCTEUR D'UNE FEUILLE SUPPORT

(43) Veröffentlichungstag der Anmeldung: 31.07.2024
(73) Patentinhaber: MKE Metall- und Kunststoffwaren Erzeugungsgesellschaft m.b.H., 3860 Heidenreichstein (AT)
(72) Erfinder: Hörndl, Michael, 3830 Waidhofen an der Thaya (AT)
(74) Vertreter: Puchberger & Partner Patentanwälte

(56) Entgegenhaltungen:
- EP-A2- 1 300 873
- EP-B1- 1 614 649
- WO-A1-2007/139090
- WO-A1-2011/068174
- CN-A- 115 071 137
- JP-A- 2017 147 074
- JP-B2- 4 802 213
- KR-A- 20190 036 514
- KR-B1- 102 279 381
- TW-A- 202 113 999
- US-A- 5 328 546
- US-B2- 10 286 643
- US-B2- 8 789 568
- FUJIPOLY AMERICA: "Standard Performance Gap Filler Pads from Fujipoly America", 2 February 2023 (2023-02-02), XP093071005, Retrieved from the Internet <URL:https://www.youtube.com/watch?v=1WHIPVzC6Hc> [retrieved on 20230805]
- LAIRD ET AL: "Automated Gap Filler Application", 2 March 2022 (2022-03-02), XP093071006, Retrieved from the Internet <URL:https://www.youtube.com/watch?v=9s-vJIupAbU> [retrieved on 20230805]

## Beschreibung

Die Erfindung betrifft eine Vorrichtung, eine Anordnung und ein Verfahren gemäß den Merkmalen der unabhängigen Patentansprüche.

Zur funktionellen Verbindung von Komponenten elektronischer oder elektrischer Geräte ist es bekannt, sogenannte Wärmeleitpads oder "Gap Pads" zwischen den Komponenten vorzusehen. Beispielsweise müssen auf Elektronikkomponenten oft Kühlkörper angebracht werden, um die Wärme der Elektronikkomponenten abzuführen. Um die Wärmeleitung von der Elektronikkomponente zu dem Kühlkörper zu verbessern, wird zwischen diesen Komponenten ein Wärmeleitpad vorgesehen.

Wärmeleitpads sind meist vorgefertigte, auf Trägerfolien angebrachte Körper. Sie weisen eine pastöse, teigige, knetmasseartig und/oder gummiartige Konsistenz auf.

Aus dem Stand der Technik sind verschiedene Vorrichtungen zum Abziehen von Folien von Gegenständen oder Abgreifen von Gegenständen von Folien bekannt. Beispielsweise beschreibt das Dokument WO2007139090A1 eine Vorrichtung zum Ablösen einer Folie von einem Substrat. Das Dokument KR20190036514A offenbart eine Vorrichtung zum Abnehmen von Wärmeleitern von einer Kupferfolie. Das Dokument JP2017147074A beschreibt eine Vorrichtung zum Bereitstellen von Wärmeleitern mit möglichst geringer Positionsabweichung.

Bevorzugt können Wärmeleitpads einfach plastisch verformt werden, sodass sie sich an die wärmeleitend zu verbindenden Elemente anpassen können. Insbesondere weisen sie keine, oder zumindest keine ausgeprägte, Formstabilität auf. Insbesondere weisen sie kein Formgedächtnis auf und/oder werden, wenn sie verformt werden, plastisch und nicht elastisch verformt.

Während Wärmeleitpads mit gummiartiger Struktur relativ einfach verarbeitbar sind, ist die automatische Verarbeitung vorgefertigter Wärmeleitpads mit pastöser bis festpastöser Konsistenz mit großen technischen Hürden verbunden.

So muss das weiche, instabile Wärmeleitpad von der flexiblen Trägerfolie abgelöst und auf eine vorbestimmte Position an einem anderen Teil aufgebracht werden. Das automatisierte Handling der solchen Wärmeleitpads ist einerseits durch die Flexibilität bzw. Steifigkeit der Trägerfolie und andererseits durch die mangelnde Formstabilität der Wärmeleitpads erschwert.

Aufgabe der Erfindung ist es nun, eine Vorrichtung, ein Verfahren und eine Anordnung zu schaffen, die ein automatisiertes Ablösen eines Wärmeleitpads von einer flexiblen Trägerfolie ermöglichen. Die Erfindung bezieht sich insbesondere auf Wärmeleitpads mit pastös-fester, also knetmasseähnlicher, Konsistenz. Jedoch kann die Vorrichtung gegebenenfalls auch Wärmeleitpads mit anderer Konsistenz, beispielsweise mit festerer Konsistenz, verarbeiten.

Die erfindungsgemäße Aufgabe wird insbesondere durch die Merkmale der unabhängigen Patentansprüche gelöst.

Die Erfindung betrifft eine Vorrichtung zum automatisierten Ablösen eines Wärmeleitpads von der Vorderseite einer flexiblen Trägerfolie.

Die Vorrichtung umfasst eine Spannvorrichtung mit einem öffen- und schließbaren Haltegreifer, zum Greifen und Halten der Trägerfolie.

Die Vorrichtung umfasst eine Abziehvorrichtung mit einer Abziehkante zur Umlenkung der Trägerfolie um deren Rückseite.

Die Vorrichtung umfasst einen Abziehantrieb, der den Abstand der Abziehkante von dem Haltegreifer vergrößert, um die Trägerfolie über die Abziehkante zu bewegen, insbesondere zu ziehen, und dadurch die Trägerfolie von dem Wärmeleitpad abzuziehen.

Erfindungsgemäß ist vorgesehen, dass die Spannvorrichtung, abgesehen von dem Haltegreifer, einen Spanngreifer und einen Spannantrieb umfasst, dass der Haltegreifer und Spanngreifer dazu eingerichtet sind, eine Trägerfolie mit Wärmeleitpads in unterschiedlichen bzw. gegenüberliegenden Bereichen zu halten und dass der Spannantrieb dazu eingerichtet ist, Trägerfolie zwischen dem Haltegreifer und Spanngreifer zu spannen.

Gegebenenfalls ist vorgesehen, dass die Abziehvorrichtung, abgesehen von der Abziehkante eine Umlenkleiste aufweist.

Gegebenenfalls ist vorgesehen, dass die Abziehvorrichtung dazu eingerichtet ist, die Trägerfolie z-förmig umzulenken.

Gegebenenfalls ist vorgesehen, dass der Abziehantrieb die Abziehvorrichtung von dem Haltegreifer weg bewegt, und dazu eingerichtet ist, ein Wärmeleitpad von der, zwischen Haltegreifer und Abziehvorrichtung gespannten und durch die Abziehvorrichtung z-förmig umgelenkten, Trägerfolie zu lösen.

Gegebenenfalls ist vorgesehen, dass der Abziehantrieb die Abziehvorrichtung von dem Haltegreifer Richtung Spanngreifer bewegt, und dazu eingerichtet ist, ein Wärmeleitpad von der, zwischen Haltegreifer und Spanngreifer gespannten und durch die Abziehvorrichtung z-förmig umgelenkten, Trägerfolie zu lösen.

Gegebenenfalls ist ein Abnahmegreifer zum Halten des Wärmeleitpads während dem Ablösen von der Trägerfolie vorgesehen.

Gegebenenfalls ist vorgesehen, dass der Abnahmegreifer eine an ein Sauggebläse angeschlossene Saugplatte mit einer Abnahmefläche und mit, in der Abnahmefläche vorgesehenen, Saugöffnungen umfasst.

Gegebenenfalls ist vorgesehen, dass eine Einlegevorrichtung zum Einlegen eines Blatts bzw. eines Bogens einer Trägerfolie mit mindestens einem Wärmeleitpad, bevorzugt mit mehreren Wärmeleitpads, vorgesehen ist.

Gegebenenfalls ist eine Positioniervorrichtung zur exakten Positionierung und Ausrichtung eines Blatts bzw. eines Bogens einer Trägerfolie mit mindestens einem Wärmeleitpad, bevorzugt mit mehreren Wärmeleitpads, vorgesehen.

Gegebenenfalls ist eine Einführvorrichtung mit mindestens einem Einführelement zum Einführen eines Bereichs der Trägerfolie in den geöffneten Haltegreifer und gegebenenfalls eines anderen Bereichs der Trägerfolie in den geöffneten Spanngreifer vorgesehen.

Die Erfindung betrifft ferner eine Anordnung einer flexiblen Trägerfolie, auf deren Vorderseite mindestens ein Wärmeleitpad vorgesehen ist, und einer Vorrichtung nach einem der vorangegangenen Ansprüche.

Erfindungsgemäß umfasst die Anordnung eine Spannvorrichtung mit einem öffen- und schließbaren Haltegreifer, der die Trägerfolie greift und hält.

Erfindungsgemäß umfasst die Anordnung eine Abziehvorrichtung mit einer Abziehkante, um die die Trägerfolie um deren Rückseite umgelenkt ist.

Erfindungsgemäß umfasst die Anordnung einen Abziehantrieb, der den Abstand der Abziehkante von dem Haltegreifer vergrößert, wodurch die Trägerfolie über die Abziehkante bewegt und von dem Wärmeleitpad abgezogen wird.

Die Erfindung betrifft ferner ein Verfahren zum automatisierten Ablösen eines Wärmeleitpads von der Vorderseite einer flexiblen Trägerfolie
Das Verfahren umfasst folgende Schritte:
- Greifen und Halten der Trägerfolie mit einem Haltegreifer einer Spannvorrichtung,
- Umlenken der Trägerfolie mit deren Rückseite um eine Abziehkante einer Abziehvorrichtung,
- Vergrößern des Abstands zwischen der Abziehkante und dem Haltegreifer durch einen Abziehantrieb, wodurch die Trägerfolie über die Abziehkante bewegt und von dem Wärmeleitpad abgezogen wird.

Erfindungsgemäß ist vorgesehen, dass die Trägerfolie, auf der Wärmeleitpads angebracht sind, in unterschiedlichen bzw. gegenüberliegenden Bereichen von einem Haltegreifer und einem Spanngreifer gehalten wird.

Erfindungsgemäß ist vorgesehen, dass die Trägerfolie durch Betätigen eines Spannantriebs zwischen dem Haltegreifer und dem Spanngreifer gespannt wird.

Gegebenenfalls ist vorgesehen, dass die Trägerfolie über die Abziehkante und eine Umlenkleiste der Abziehvorrichtung z-förmig umgelenkt wird.

Gegebenenfalls ist vorgesehen, dass der Abziehantrieb die Abziehvorrichtung von dem Haltegreifer weg bewegt und ein Wärmeleitpad von der, zwischen Haltegreifer und Abziehvorrichtung gespannten und durch die Abziehvorrichtung z-förmig umgelenkten, Trägerfolie löst.

Gegebenenfalls ist vorgesehen, dass der Abziehantrieb die Abziehvorrichtung von dem Haltegreifer Richtung Spanngreifer bewegt und dadurch ein Wärmeleitpad von der, zwischen Haltegreifer und Spanngreifer gespannten und durch die Abziehvorrichtung z-förmig umgelenkten, Trägerfolie löst.

Gegebenenfalls ist vorgesehen, dass das Wärmeleitpad beim Ablösen von der Trägerfolie von einem Abnahmegreifer gehalten wird.

Gegebenenfalls ist vorgesehen, dass ein Blatt bzw. ein Bogen einer Trägerfolie mit mindestens einem Wärmeleitpad, bevorzugt mit mehreren Wärmeleitpads, von einer Einlegevorrichtung eingelegt wird.

Gegebenenfalls ist vorgesehen, dass ein Blatt bzw. ein Bogen einer Trägerfolie mit mindestens einem Wärmeleitpad, bevorzugt mit mehreren Wärmeleitpads, von einer Positioniervorrichtung exakt positioniert und ausgerichtet wird.

Gegebenenfalls ist vorgesehen, dass ein Bereich der Trägerfolie in den geöffneten Haltegreifer, und gegebenenfalls ein anderer Bereich der Trägerfolie in den geöffneten Spanngreifer, von einer Einführvorrichtung eingeführt wird.

In allen Ausführungsformen ist bevorzugt vorgesehen, dass das beschriebene Verfahren auf der beschriebenen Vorrichtung ausgeführt wird. Die Vorrichtung und die Trägerfolie samt Wärmeleitpads bilden zusammen eine Anordnung.

Gegebenenfalls ist vorgesehen, dass die Trägerfolie in Form eines Blattes bzw. eines Bogens ausgestaltet ist und mindestens ein Wärmeleitpad, bevorzugt eine Vielzahl von Wärmeleitpads, trägt.

Gegebenenfalls ist vorgesehen, dass das mindestens eine Wärmeleitpad lösbar an der Trägerfolie klebt bzw. über eine lösbare, stoffschlüssige Verbindung an der Trägerfolie angebracht ist.

An der außenliegenden Seite können die Wärmeleitpads mit einer nicht klebenden Schicht versehen oder abgedeckt sein.

Bevorzugt ist vorgesehen, dass die Wärmeleitpads von Einzelbögen der Trägerfolie abgezogen und auf Bauteile aufgeklebt werden.

Bevorzugt ist vorgesehen, dass die Wärmeleitpads lösbar an der Trägerfolie kleben und durch die vorliegende Vorrichtung von dieser abgezogen werden.

Bevorzugt ist vorgesehen, dass die Wärmeleitpads kein Formgedächtnis aufweisen und/oder eine pastöse und/oder knetmasseartige Konsistenz aufweisen.

Bevorzugt ist vorgesehen, dass das Zuführen der Trägerfolie mit den Wärmeleitpads, das Abnehmen der Wärmeleitpads von der Trägerfolie und die Bereitstellung zum Abtransport bzw. für das Aufbringen auf ein weiteres Bauteil automatisiert bzw. vollautomatisch abläuft.

Bevorzugt ist vorgesehen, dass die Wärmeleitpads etwa 1 bis 10 mm, gegebenenfalls 1 bis 4 mm, bevorzugt 2 mm, dick sind. Bevorzugt ist vorgesehen, dass die Wärmeleitpads thermisch leitende aber elektrisch isolierende Pads sind. Bevorzugt sind die Wärmeleitpads selbstklebend ausgebildet.

In allen Ausführungsformen kann vorgesehen sein, dass die höchstzulässige Kraft zur Bearbeitung bzw. zur Verarbeitung der Wärmeleitpads < 20 N, insbesondere etwa 10 N beträgt. Die Wärmeleitpads sind bevorzugt vorgefertigt bzw. vorgeformt auf der Trägerfolie angebracht. Dies unterscheidet Wärmeleitpads von Wärmeleitpasten, die flüssig bis pastös sind und über Depositoren aufgetragen werden.

Bevorzugt ist vorgesehen, dass das Wärmeleitpad zum Zeitpunkt des Abziehens der Trägerfolie von einem Abnahmegreifer gehalten wird. Insbesondere soll das Wärmeleitpad während des Abziehens der Trägerfolie unbewegt bzw. ortsfest angeordnet sein.

Bevorzugt wird die Trägerfolie beim Abziehen von dem Wärmeleitpad über die Abziehkante bewegt, insbesondere gezogen und/oder geschoben und/oder von dem Wärmeleitpad abgerollt.

Der Abnahmegreifer kann insbesondere als Saugkopf ausgebildet sein. Bevorzugt ist vorgesehen, dass die Trägerfolie eine Dicke von < 1 mm, bevorzugt < 0,7 mm und besonders bevorzugt < 0,5 mm aufweist. Gemäß einer möglichen Ausführungsform weist die Trägerfolie eine Dicke von etwa 0,6 mm auf.

Der Radius der Abziehkante soll an die Dicke der Trägerfolie angepasst werden, wobei der Radius der Abziehkante tendenziell kleiner sein kann, je dünner bzw. je flexibler die Trägerfolie ist.

Die Umlenkleiste kann beispielsweise eine drehbare Walze bzw. drehbare Räder umfassen, die beispielsweise als Nadellager ausgebildet sind oder Nadellager umfassen.

Bevorzugt ist vorgesehen, dass die Abnahmegreifer an ein Sauggebläse angeschlossen sind, wobei das Sauggebläse beispielsweise als Industriesauger ausgebildet ist. Dieser erreicht beispielsweise einen Unterdruck von 0,3 bar und einen Volumenstrom von mehreren m³/h, beispielsweise von 200-300m³/h.

Bevorzugt umfasst die Vorrichtung eine oder mehrere Eingabeladen, in denen, beispielsweise gestapelt oder einzeln, Trägerfolien mit darauf befindlichen Wärmeleitpads vorgesehen sein können. Die Einlegevorrichtung kann die Trägerfolien mit den Wärmeleitpads zur weiteren Verarbeitung von diesem Stapel bzw. von den Eingabeladen zur weiteren Verarbeitung entnehmen und an einer anderen Stelle der Vorrichtung einlegen. Hierzu kann die Einlegevorrichtung ein Transfershuttle umfassen.

Bei zwei Eingabeladen bzw. zwei Stapeln von Trägerfolien kann die Einlegevorrichtung jeweils aus einer Lade Trägerfolien entnehmen, während die andere Lade nachbestückt wird. Das Greifen zum Transport der Trägerfolien kann beispielsweise über Vakuumgreifer erfolgen.

Zur Ausrichtung der Trägerfolien in der Vorrichtung kann eine Positioniervorrichtung vorgesehen sein. Diese kann Ausrichtleisten umfassen, die, beweglich oder feststehend, eine Lagezentrierung der Trägerfolie ermöglichen. Je nach Gleitfähigkeit der Trägerfolie bzw. der Wärmeleitpads auf der Unterlage kann optional ein Luftkissenboden angeordnet sein, auf dem die Wärmeleitpads bzw. die Trägerfolien schweben.

Bevorzugt wird die Trägerfolie mit den Wärmeleitpads zum Ablösen auf einer Auflagefläche aufgelegt, wobei die Auflagefläche bevorzugt eine Öffnung aufweist, durch die das abzulösende Wärmeleitpad entnommen werden kann bzw. durch die der Abnahmegreifer hindurchragt und/oder mit dem Wärmeleitpad in Kontakt steht.

Nach dem Ausrichten der Trägerfolie ist bevorzugt vorgesehen, dass zwei seitliche Abschnitte der Trägerfolie in den Haltegreifer und den Spanngreifer gebogen und von den beiden Greifern erfasst werden. Dies geschieht über die Einführvorrichtung bzw. deren Einführelemente.

Bevorzugt ist vorgesehen, dass der Abstand der Abziehleiste mit der darauf vorgesehenen Abziehkante gegenüber der Umlenkleiste verändert werden kann. Dies, beispielsweise um die Trägerfolie in den Haltegreifer einführen zu können und insbesondere auch dazu, dass die Trägerfolie in der Abziehvorrichtung Z-förmig geführt werden kann. Im Wesentlichen werden die Abziehleiste und die Umlenkleiste voneinander entfernt, um die Trägerfolie zwischen diesen beiden Elementen hindurchzuführen. Die Abziehleiste und die Umlenkleiste können miteinander gekoppelt werden, sodass diese beiden Leisten gemeinsam bewegt werden können, um die Wärmeleitpads von der Trägerfolie abzuziehen.

Die Abnahmegreifer sind bewegbar ausgebildet und transportieren die abgenommenen Wärmeleitpads ab, um sie beispielsweise von einem Roboter abnehmen zu lassen. Um dennoch eine Verbindung mit dem Sauggebläse zu ermöglichen, sind bevorzugt flexible Schläuche vorgesehen, die das Sauggebläse mit dem jeweiligen Abnahmegreifer verbinden.

Je nachdem, wie viele Wärmeleitpads nebeneinander auf der Trägerfolie angebracht sind und gleichzeitig abgenommen werden, können mehrere Abnahmegreifer vorgesehen sein. Sind beispielsweise drei Wärmeleitpads nebeneinander auf der Trägerfolie angeordnet, die gleichzeitig durch Betätigen der Abziehvorrichtung abgenommen werden, so sind bevorzugt drei Abnahmegreifer vorgesehen, die jeweils ein Wärmeleitpad tragen und beispielsweise an einen Roboter übergeben.

Bei mehreren nebeneinander angeordneten Wärmeleitpads, die gleichzeitig abgenommen werden, weisen die Abnahmekante und die gegebenenfalls vorgesehene Umlenkleiste eine entsprechende Länge auf. Insbesondere erstrecken sich die Abnahmekante und die gegebenenfalls vorgesehene Umlenkleiste über die gesamte Breite der Trägerfolie, entlang welcher gleichzeitig Wärmeleitpads abgenommen werden.

Gegebenenfalls ist vorgesehen, dass zur Übergabe der Wärmeleitpads an einen Roboter die Saugwirkung des jeweiligen Abnahmegreifers gestoppt wird. Dies kann beispielsweise über ein Ventil erfolgen, das schließt und somit die Saugleistung reduziert oder auf null senkt.

Gegebenenfalls ist vorgesehen, dass eine Trägerfolie, von der alle Wärmeleitpads abgenommen wurden, über eine Folienausschleusung entfernt wird.

Die Erfindung wird nun anhand von schematischen Darstellungen weiter beschrieben.
Fig. 1 zeigt eine schematische Seitenansicht von Komponenten einer Vorrichtung.
Die Fig. 2a bis 2e zeigen Schritte beim Ablösen sowie ein Detail des Abnahmegreifers.
Die Fig. 3a bis 3d zeigen Komponenten einer Vorrichtung bzw. einer Anordnung beim Ablösen.

Wenn nicht anders angegeben, so entsprechen die Bezugszeichen folgenden Komponenten: Wärmeleitpad 1, Trägerfolie 2, Vorderseite (der Trägerfolie) 3, Rückseite (der Trägerfolie) 4, Spannvorrichtung 5, Haltegreifer 6, Abziehvorrichtung 7, Abziehkante 8, Abziehantrieb 9, Abstand (Abziehkante zum Haltegreifer) 10, Spanngreifer 11, Spannantrieb 12, Umlenkleiste 13, Abnahmegreifer 14, Sauggebläse 15, Abziehleiste 16, Abnahmefläche 17, Saugöffnungen 18, Einlegevorrichtung 19, Positioniervorrichtung 20, Einführvorrichtung 21, Einführelement 22.

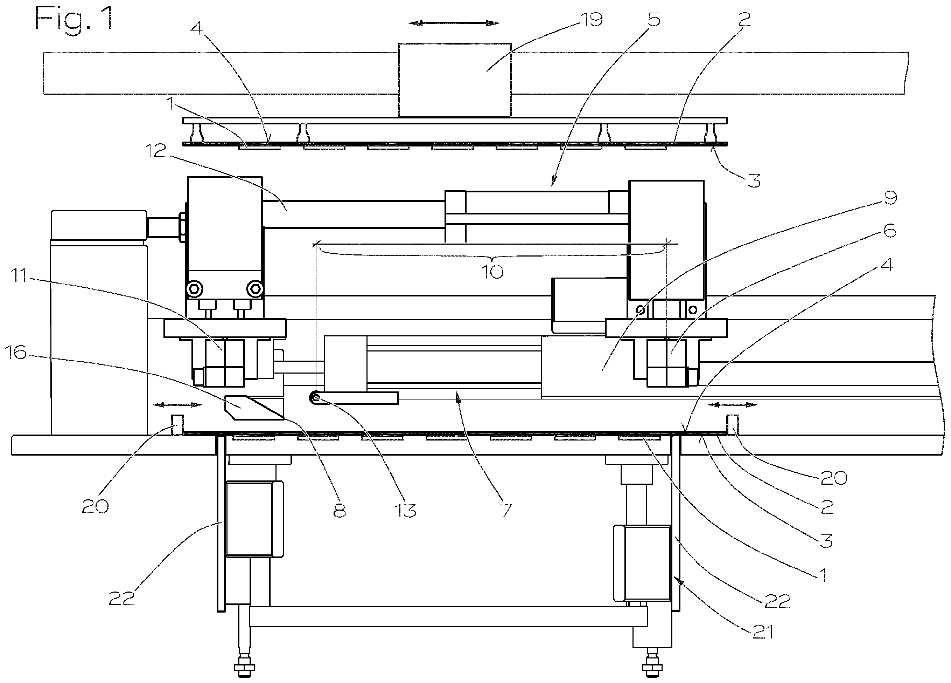

**Fig. 1** zeigt eine schematische Ansicht von Komponenten einer Vorrichtung bzw. einer Anordnung einer Vorrichtung mit einer Trägerfolie 2, an deren Vorderseite 3 Wärmeleitpads 1 vorgesehen sind. Mehrere Trägerfolien 2 mit Wärmeleitpads 1 können beispielsweise in einem nicht dargestellten Stapel gelagert und durch eine Einlegevorrichtung 19 eingelegt werden. Beispielsweise umfasst die Einlegevorrichtung 19 mehrere Greifer, wie beispielsweise Sauggreifer, die die Trägerfolie 2 an ihrer Rückseite 4 greifen können.

In allen Ausführungsformen ist bevorzugt vorgesehen, dass die Trägerfolie 2 in Form eines Blattes bzw. eines Bogens ausgestaltet ist und mindestens ein, bevorzugt eine Vielzahl von Wärmeleitpads 1 trägt.

Die Vorrichtung kann eine Positioniervorrichtung 20 umfassen, durch die die Trägerfolie 2 zur weiteren Bearbeitung exakt positioniert und ausgerichtet werden kann.

In allen Ausführungsformen ist bevorzugt vorgesehen, dass das mindestens eine Wärmeleitpad 1 an der Trägerfolie 2 klebt bzw. über eine lösbare stoffschlüssige Verbindung an der Trägerfolie 2 hält. An der außenliegenden Seite können die Wärmeleitpads mit einer nicht klebenden Schicht versehen sein, wodurch die Wärmeleitpads 1 an dieser Außenseite nicht kleben. Dies vereinfacht die Weiterverarbeitung. Diese Schicht kann gegebenenfalls abgezogen werden, sodass die Wärmeleitpads 1 bei bestimmungsgemäßer Verwendung eine gute Verbindung mit Komponenten auf beiden Seiten ermöglichen.

Die Positioniervorrichtung 20 kann beispielsweise, wie in Fig. 1 schematisch dargestellt, Positionierleisten umfassen, die bewegbar angetrieben oder feststehend eine Lagezentrierung der Trägerfolie 2 ermöglichen.

Die Vorrichtung umfasst in der vorliegenden Ausführungsform einen Haltegreifer 6, der die Trägerfolie 2 insbesondere in deren Randbereich hält. Zudem umfasst die Vorrichtung eine Abziehvorrichtung 7, die dazu eingerichtet ist, die Trägerfolie 2 von dem Wärmeleitpad 1 abzuziehen, sodass das Wärmeleitpad 1 weiterverarbeitet bzw. appliziert werden kann.

In der vorliegenden Ausführungsform umfasst die Vorrichtung eine Spannvorrichtung 5 mit einem Haltegreifer 6 und einem Spanngreifer 11. Der Haltegreifer 6 und der Spanngreifer 11 halten die Trägerfolie 2 in unterschiedlichen, insbesondere in gegenüberliegenden, Bereichen der Trägerfolie 2. Durch Betätigen eines Spannantriebs 12 der Spannvorrichtung 5 können der Haltegreifer 6 und der Spanngreifer 11 gegenüber einander bewegt werden bzw. kann durch Betätigen des Spannantriebs 12 die Trägerfolie 2 zwischen dem Spanngreifer 11 und dem Haltegreifer 6 gespannt werden.

Die Trägerfolie 2 ist zum Entfernen der Wärmeleitpads 1 von der Trägerfolie 2 mit einer Abziehvorrichtung 7 in Wirkkontakt. Die Abziehvorrichtung 7 umfasst eine Abziehkante 8. Die Trägerfolie 2 ist mit ihrer Rückseite 4 um diese Abziehkante 8 gelegt bzw. umgelenkt. Durch eine Relativbewegung der Abziehkante 8 gegenüber der Trägerfolie 2 im Bereich eines Wärmeleitpads 1 kann die Trägerfolie 2 vom Wärmeleitpad 1 abgezogen werden. Hierzu ist ein Abziehantrieb 9 vorgesehen, der die Abziehkante 8 bewegt.

Zusätzlich zur Abziehkante 8 kann die Abziehvorrichtung 7 eine Umlenkleiste 13 umfassen. Die Umlenkleiste 13 kann in allen Ausführungsformen beispielsweise eine drehbar gelagerte Walze oder Rolle umfassen, wodurch die Reibung zwischen der Umlenkleiste 13 und damit auch der Abziehvorrichtung 7 gegenüber der Trägerfolie 2 verringert wird.

Insbesondere kann die Umlenkleiste 13 einen größeren Umlenkradius als die Abziehkante 8 umfassen. Die Abziehkante 8 ist in allen Ausführungsformen bevorzugt derart ausgebildet, dass sie die Trägerfolie 2 derart umlenkt, dass die Wärmeleitpads 1 von der Trägerfolie 2 gelöst werden können.

Insbesondere kann in allen Ausführungsformen vorgesehen sein, dass die Abziehkante 8 eine spitzwinkelige Umlenkung der Trägerfolie 2 bewirkt. Die Abziehkante 8 kann in allen Ausführungsformen einen Radius aufweisen, der klein genug ist, damit sich die Wärmeleitpads 1 von der Trägerfolie 2 lösen. Der Radius der Abziehkante 8 sollte jedoch so groß gewählt sein, dass die Trägerfolie 2 nicht zerstört bzw. zerschnitten wird. Insbesondere kann durch eine ausreichend große Gestaltung des Radius der Abziehkante 8 auch die Reibung zwischen der Trägerfolie 2 und der Abziehvorrichtung 7 in einem vorteilhaften Bereich gehalten werden.

Zur Bewegung der Abziehkante und gegebenenfalls der Umlenkleiste 13 weist die Abziehvorrichtung 7 bevorzugt einen Abziehantrieb 9 auf. Durch diesen kann der Abstand 10 zwischen der Abziehkante 8 und dem Haltegreifer 6 vergrößert werden. So kann die Abziehkante 8 entlang der Trägerfolie 2 bewegt werden, um die Wärmeleitpads 1 von dieser zu lösen.

Um die Trägerfolie 2 in den Haltegreifer 6 bzw. den Spanngreifer 11 einführen zu können, ist eine Einführvorrichtung 21 vorgesehen. Diese umfasst für den Haltegreifer 6 und gegebenenfalls für den Spanngreifer 11 jeweils ein Einführelement 22. Dieses Einführelement 22 kann die Trägerfolie 2 in einem ihrer Bereiche jeweils in den Haltegreifer 6 bzw. in den Spanngreifer 11 einführen. Durch Betätigen der Greifer 6, 11 kann die Trägerfolie 2 gegriffen und gehalten werden.

Die Funktion der Komponenten der Vorrichtung, der Anordnung und auch das Verfahren werden anhand der weiteren Figuren im Detail beschrieben.

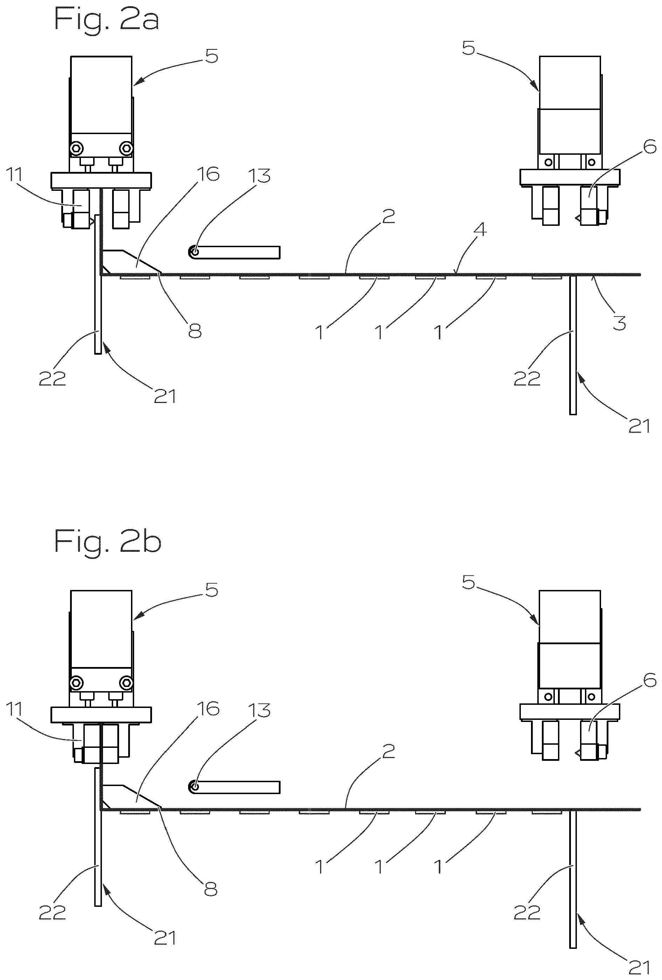

**Fig. 2a** zeigt Komponenten der Vorrichtung bzw. der Anordnung in einer ersten Stellung. Die Trägerfolie 2 mit dem Wärmeleitpad 1 ist in die Vorrichtung eingelegt. Die Trägerfolie 2 ist über ein Einführelement 22 der Einführvorrichtung 21 in den Spanngreifer 11 der Spannvorrichtung 5 eingeführt. Hierzu kann, wie in der vorliegenden Ausführungsform, die Abziehleiste 16, die die Abziehkante 8 trägt, in den Bereich des Spanngreifers 11 verschoben werden. Die Abziehleiste 16 bildet eine Führungsfläche bzw. einen Führungskörper für die Trägerfolie 2. In weiterer Folge wird das Einführelement 22 der Einführvorrichtung 21 betätigt, um die Trägerfolie 2 in den Spanngreifer 11 einzuführen. In der vorliegenden Ausführungsform ist das Einführelement 22 ein bewegbarer Fortsatz bzw. ein bewegbares Schwert, das die Trägerfolie 2 umbiegt und in den Spanngreifer 11 einführt. In einem weiteren Schritt wird der Spanngreifer 11 geschlossen, wie in Fig. 2b dargestellt ist.

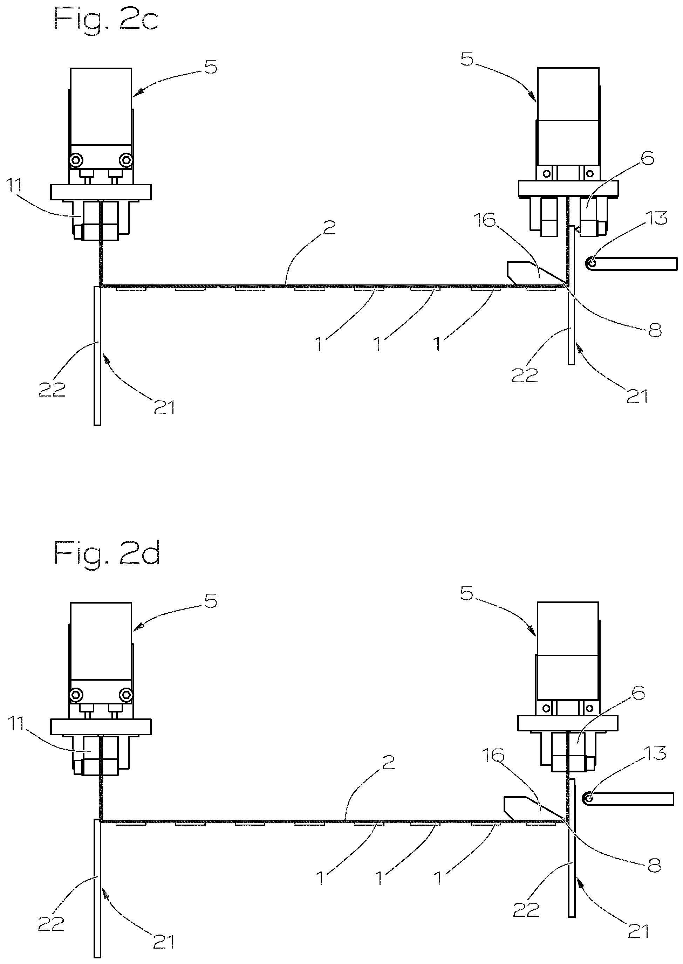

**Fig. 2c** zeigt einen weiteren Schritt, in dem die Trägerfolie 2 in einem anderen Bereich in den Haltegreifer 6 eingeführt wird. Hierzu wird wiederum ein Einführelement 22 der Einführvorrichtung 21 betätigt. Die Funktionsweise entspricht der Funktionsweise, wie sie in Fig. 2b beschrieben ist. Auch hier kann vorgesehen sein, dass die Trägerfolie 2 um die Abziehleiste 16 gebogen wird. Durch Betätigen des Einführelements 22 der Einführvorrichtung 21 wird die Trägerfolie 2 im vorliegenden Fall um die Abziehkante 8 Richtung Haltegreifer 6 gebogen. Die Trägerfolie wird insbesondere zwischen der Abziehleiste und der Umlenkleiste durchgeführt. Hierzu kann die Entfernung zwischen der Umlenkleiste 13 und der Abziehleiste 16 vergrößert werden.

Wie in **Fig. 2d** dargestellt, wird anschließend der Haltegreifer 6 geschlossen. In dieser Stellung ist die Trägerfolie 2 vom Haltegreifer 6 und dem Spanngreifer 11 in unterschiedlichen Bereichen gehalten. In weiterer Folge wird die Einführvorrichtung 21 zurückgezogen, sodass deren Einführelement(e) 22 den weiteren Ablauf des Verfahrens nicht stören.

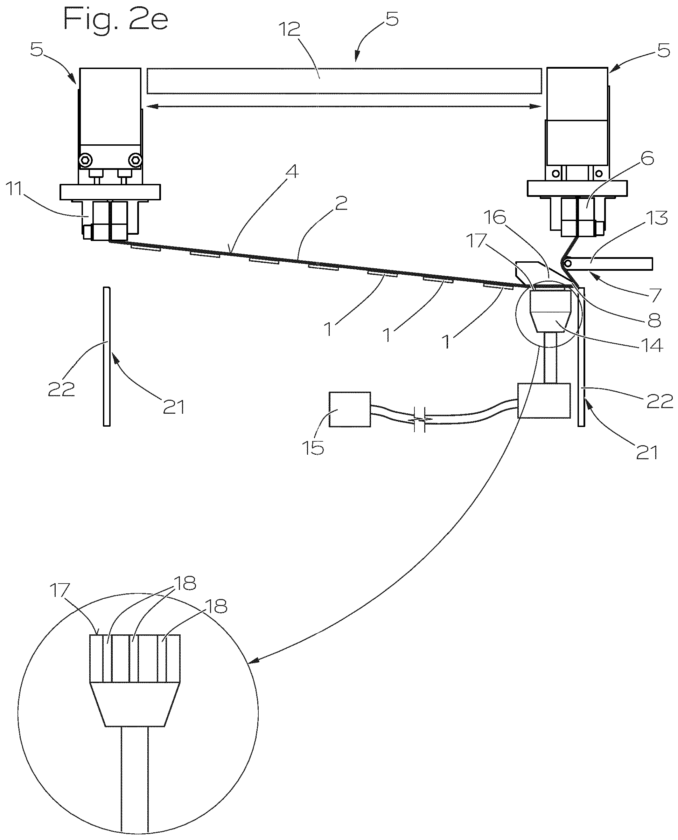

In einem nächsten Schritt, schematisch dargestellt in **Fig. 2e****,** wird die Trägerfolie 2 mit den Wärmeleitpads 1 gespannt. Hierzu kann ein Spannantrieb 12 der Spannvorrichtung 5 vorgesehen sein, der den Abstand des Haltegreifers 6 gegenüber dem Spanngreifer 11 vergrößert und so die Trägerfolie 2 spannt.

Zusätzlich oder alternativ kann eine Spannung dadurch bewirkt werden, dass die Umlenkleiste 13 relativ zur Abziehkante 8 bewegt wird. Insbesondere kann die Entfernung zwischen der Umlenkleiste 13 und der Abziehleiste 16 verkleinert werden. Dies kann beispielsweise über einen eigenen Antrieb erfolgen. In dieser Stellung ist die Trägerfolie 2 in der Abziehvorrichtung 7 z-förmig umgelenkt. Die Trägerfolie 2 ist mit ihrer Rückseite 4 um die Abziehkante 8 umgelenkt. Die Vorrichtung ist bereit, um ein erstes Wärmeleitpad 1 von der Trägerfolie 2 zu lösen.

Hierzu ist in der vorliegenden Ausführungsform, in bevorzugter Weise in allen Ausführungsformen, ein Abnahmegreifer 14 vorgesehen. Dieser Abnahmegreifer 14 steht mit jenem Wärmeleitpad 1 in Kontakt, das abgenommen werden soll. In der vorliegenden Ausführungsform ist der Abnahmegreifer 14 mit einer Abnahmefläche 17 an das Wärmeleitpad 1 angelegt. In der Abnahmefläche 17 können Saugöffnungen 18 vorgesehen sein, die an ein Sauggebläse 15 angeschlossen sind. Durch dieses Sauggebläse 15 und die Saugöffnungen 18 kann an der Abnahmefläche 17 ein Unterdruck erzeugt werden, der das Wärmeleitpad 1 an dem Abnahmegreifer 14 hält. Bevorzugt ist das Sauggebläse 15 ein konstant saugendes Gebläse, das über ein Regelventil bzw. ein Steuerventil einen konstanten Unterdruck erzeugt, wenn ein Wärmeleitpad 1 an der Abnahmefläche 17 anliegt.

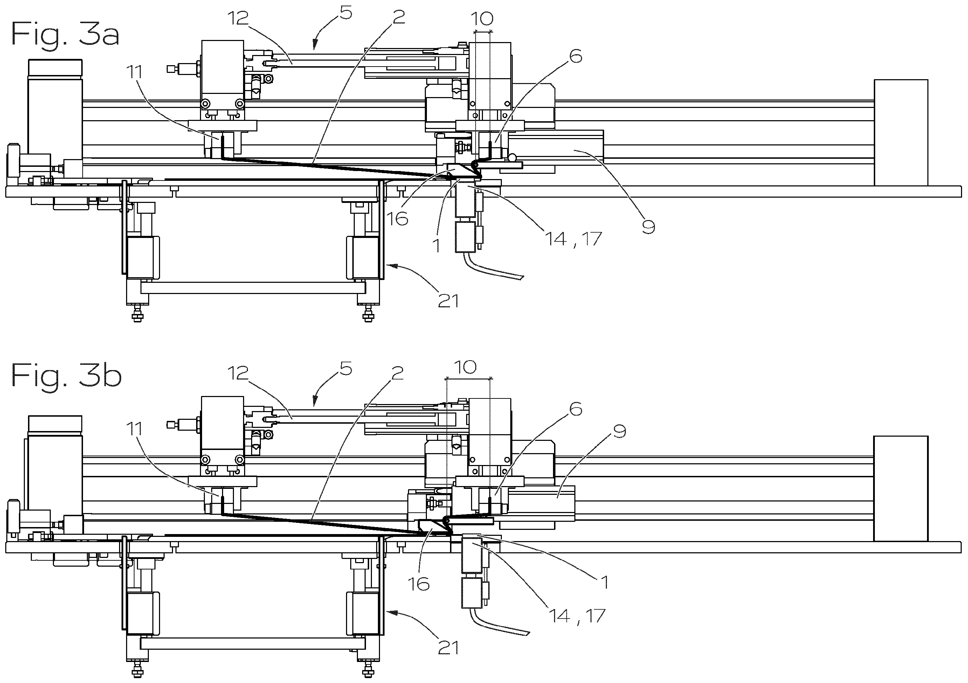

Mögliche weitere Schritte sind in den **Fig. 3a bis 3d** dargestellt. **Fig. 3a** zeigt im Wesentlichen dieselbe Position wie Fig. 2e, wobei auch weitere Komponenten dargestellt sind. Um ein Wärmeleitpad 1 von der Trägerfolie 2 zu lösen, wird die Abziehkante 8 von einem Abziehantrieb 9 bewegt. Dadurch wird der Abstand 10 zwischen Haltegreifer 6 und der Abziehkante 8 vergrößert. Die Trägerfolie 2 wird dabei entlang der Abziehkante 8 umgelenkt und bewegt, sodass diese von dem Wärmeleitpad 1 abgezogen wird. Das Wärmeleitpad 1 wird dabei von dem Abnahmegreifer 14 gehalten. In weiterer Folge kann der Abnahmegreifer 14 das Wärmeleitpad 1 abtransportieren und zur Weiterverarbeitung übergeben oder direkt auf ein Bauteil applizieren.

In **Fig. 3b** ist dargestellt, wie der Abstand 10 zwischen Haltegreifer 6 und Abziehkante 8 vergrößert ist, sodass die Trägerfolie 2 von einem ersten Wärmeleitpad 1 abgezogen ist, wobei sich dieses Wärmeleitpad 1 auf der Abnahmefläche 17 des Abnahmegreifers 14 befindet.

In allen Ausführungsformen kann vorgesehen sein, dass entlang der Bewegungsrichtung der Abziehkante 8 bzw. entlang des Verlaufs der Trägerfolie 2 mehrere Wärmeleitpads 8 nebeneinander angeordnet sind.

Um nun ein weiteres Wärmeleitpad 1 von der Trägerfolie 2 abzunehmen, wird die Trägerfolie 2 im Bereich des weiteren Wärmeleitpads 1 wiederum in den Bereich des Abnahmegreifers 14 bewegt. Grundsätzlich wäre es auch möglich, den Abnahmegreifer 14 zu bewegen. In der vorliegenden Ausführungsform ist jedoch vorgesehen, dass die Komponenten der Vorrichtung bewegt werden, um das weitere Wärmeleitpad 1 in den Bereich des Abnahmegreifers 14 zu bringen. Hierzu kann die Spannvorrichtung 5 mit ihrem Haltegreifer 6 und ihrem Spanngreifer 11, beispielsweise entlang des Verlaufs der Trägerfolie 2, bewegt werden. Der Abnahmegreifer 14 kann ebenfalls bewegt werden, um die Wärmeleitpads 1 abzutransportieren, jedoch ist bevorzugt vorgesehen, dass das Trennen eines Wärmeleitpads 1 von der Trägerfolie 2 immer im selben Bereich auf den Abnahmegreifer 14 erfolgt.

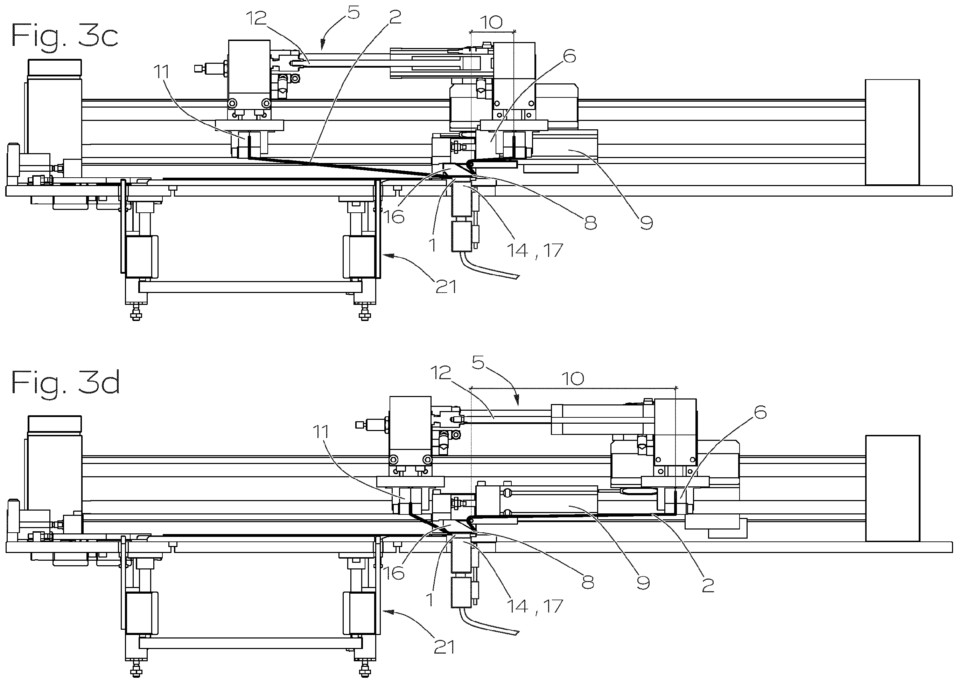

In **Fig. 3c** ist dargestellt, wie die Spannvorrichtung 5 versetzt ist, um ein weiteres Wärmeleitpad 1 wiederum auf dem Abnahmegreifer 14 abzulegen. Das Ablegen erfolgt analog zu den Figuren 3a und 3b.

**Fig. 3d** zeigt eine weitere Stellung, in der die Spannvorrichtung 5 nun soweit versetzt ist, dass das letzte Wärmeleitpad 1 von der Trägerfolie 2 abgenommen werden kann. Ist dies erfolgt, so kann die leere Trägerfolie 2 durch geeignete Mittel entfernt werden. Bevorzugt werden hierzu der Haltegreifer 6 und der Spanngreifer 11 geöffnet und die Vorrichtung kann wiederum in ihre Grundstellung verfahren.

In weiterer Folge kann ein neues Blatt einer Trägerfolie 2 mit Wärmeleitpads 1 zugeführt werden und der Prozess beginnt von neuem.

Bevorzugt geschieht der gesamte Prozess automatisiert bzw. vollautomatisch. Die Trägerfolien 2 mit den Wärmeleitpads 1 können in einem Stapel bereitgestellt werden, um von der Einlegevorrichtung 19 eingelegt zu werden. Das Greifen und Spannen der Trägerfolie 2 kann vollautomatisch erfolgen. Auch das Abnehmen der Wärmeleitpads 1 von der Trägerfolie 2 und die Weiterverarbeitung bzw. der Weitertransport durch die Abnahmegreifer 14 kann vollautomatisiert erfolgen.

## Patentansprüche

1. **Vorrichtung** zum automatisierten Ablösen eines Wärmeleitpads (1) von der Vorderseite (3) einer flexiblen Trägerfolie (2), umfassend:
- eine Spannvorrichtung (5) mit einem öffen- und schließbaren Haltegreifer (6), zum Greifen und Halten der Trägerfolie (2),
- eine Abziehvorrichtung (7) mit einer Abziehkante (8), zur Umlenkung der Trägerfolie um deren Rückseite (4),
- und einen Abziehantrieb (9), der den Abstand (10) der Abziehkante (8) von dem Haltegreifer (6) vergrößert, und dazu eingerichtet ist, die Trägerfolie (2) über die Abziehkante (8) zu bewegen und dadurch die Trägerfolie (2) von dem Wärmeleitpad (1) abzuziehen,
**dadurch gekennzeichnet,**
- **dass** die Spannvorrichtung (5), abgesehen von dem Haltegreifer (6), einen **Spanngreifer** (11) und einen Spannantrieb (12) umfasst,
- **dass** der Haltegreifer (6) und der Spanngreifer (11) dazu eingerichtet sind, eine Trägerfolie (2) mit Wärmeleitpads (1) in unterschiedlichen bzw. gegenüberliegenden Bereichen zu halten,
- und **dass** der Spannantrieb (12) dazu eingerichtet ist, Trägerfolie (2) zwischen dem Haltegreifer (6) und Spanngreifer (11) zu spannen.

2. Vorrichtung nach Anspruch 1, **dadurch gekennzeichnet,**
- **dass** die Abziehvorrichtung (7), abgesehen von der Abziehkante (8) eine Umlenkleiste (13) aufweist,
- und **dass** die Abziehvorrichtung (7) dazu eingerichtet ist, die Trägerfolie (2) z-förmig umzulenken.

3. Vorrichtung nach einem der Ansprüche 1 oder 2, **dadurch gekennzeichnet,**
- **dass** der Abziehantrieb (9) die Abziehvorrichtung (7) von dem Haltegreifer (6) weg bewegt, und dazu eingerichtet ist, ein Wärmeleitpad (1) von der, zwischen Haltegreifer (6) und Abziehvorrichtung (11) gespannten und durch die Abziehvorrichtung (7) z-förmig umgelenkten, Trägerfolie (2) zu lösen,
- oder dass der Abziehantrieb (9) die Abziehvorrichtung (7) von dem Haltegreifer (6) Richtung Spanngreifer (11) bewegt, und dazu eingerichtet ist, ein Wärmeleitpad (1) von der, zwischen Haltegreifer (6) und Spanngreifer (11) gespannten und durch die Abziehvorrichtung (7) z-förmig umgelenkten, Trägerfolie (2) zu lösen.

4. Vorrichtung nach einem der Ansprüche 1 bis 3, **dadurch gekennzeichnet,**
- **dass** ein **Abnahmegreifer** (14) zum Halten des Wärmeleitpads (1) während dem Ablösen von der Trägerfolie (2) vorgesehen ist,
- insbesondere dass der Abnahmegreifer (14) eine an ein Sauggebläse (15) angeschlossene Saugplatte mit einer Abnahmefläche (17) und mit, in der Abnahmefläche (17) vorgesehenen, Saugöffnungen (18) umfasst.

5. Vorrichtung nach einem der Ansprüche 1 bis 4, **dadurch gekennzeichnet,**
- **dass** eine **Einlegevorrichtung** (19) zum Einlegen eines Blatts bzw. eines Bogens einer Trägerfolie (2) mit mindestens einem Wärmeleitpad (1), bevorzugt mit mehreren Wärmeleitpads (1), vorgesehen ist,
- und/oder dass eine **Positioniervorrichtung** (20) zur exakten Positionierung und Ausrichtung eines Blatts bzw. eines Bogens einer Trägerfolie (2) mit mindestens einem Wärmeleitpad (1), bevorzugt mit mehreren Wärmeleitpads (1), vorgesehen ist.

6. Vorrichtung nach einem der Ansprüche 1 bis 5, **dadurch gekennzeichnet, dass** eine **Einführvorrichtung** (21) mit mindestens einem Einführelement (22) zum Einführen eines Bereichs der Trägerfolie (2) in den geöffneten Haltegreifer (6) und gegebenenfalls eines anderen Bereichs der Trägerfolie (2) in den geöffneten Spanngreifer (11) vorgesehen ist.

7. **Anordnung** einer flexiblen **Trägerfolie (2),** auf deren Vorderseite mindestens ein **Wärmeleitpad (1)** vorgesehen ist, und einer **Vorrichtung nach einem der vorangegangenen Ansprüche,** umfassend:
- eine Spannvorrichtung (5) mit einem öffen- und schließbaren Haltegreifer (6), der die Trägerfolie (2) greift und hält,
- eine Abziehvorrichtung (7) mit einer Abziehkante (8), um die die Trägerfolie (2) um deren Rückseite (4) umgelenkt ist,
- und einen Abziehantrieb (9), der den Abstand (10) der Abziehkante (8) von dem Haltegreifer (6) vergrößert, wodurch die Trägerfolie (2) über die Abziehkante (8) bewegt und von dem Wärmeleitpad (1) abgezogen wird.

8. **Verfahren** zum automatisierten Ablösen eines Wärmeleitpads (1) von der Vorderseite (3) einer flexiblen Trägerfolie (2), umfassend folgende Schritte:
- Greifen und Halten der Trägerfolie (2) mit einem Haltegreifer (6) einer Spannvorrichtung (5),
- Umlenken der Trägerfolie (2) mit deren Rückseite (4) um eine Abziehkante (8) einer Abziehvorrichtung (7),
- Vergrößern des Abstands (10) zwischen der Abziehkante (8) und dem Haltegreifer (6) durch einen Abziehantrieb (9), wodurch die Trägerfolie (2) über die Abziehkante (8) bewegt und von dem Wärmeleitpad (1) abgezogen wird,
**dadurch gekennzeichnet,**
- **dass** die Trägerfolie (2) mit Wärmeleitpads (1) in unterschiedlichen bzw. gegenüberliegenden Bereichen von einem Haltegreifer (6) und einem Spanngreifer (11) gehalten wird,
- und **dass** die Trägerfolie (2) durch Betätigen eines Spannantriebs (12) zwischen dem Haltegreifer (6) und dem Spanngreifer (11) gespannt wird.

9. Verfahren nach Anspruch 8, **dadurch gekennzeichnet**, und dass die Trägerfolie (2) über die Abziehkante (8) und eine Umlenkleiste (13) der Abziehvorrichtung (7) z-förmig umgelenkt wird.

10. Verfahren nach einem der Ansprüche 8 oder 9, **dadurch gekennzeichnet,**
- **dass** der Abziehantrieb (9) die Abziehvorrichtung (7) von der Haltegreifer (6) weg bewegt und ein Wärmeleitpad (1) von der, zwischen Haltegreifer (6) und Abziehvorrichtung (7) gespannten und durch die Abziehvorrichtung (7) z-förmig umgelenkten, Trägerfolie (2) löst,
- oder dass der Abziehantrieb (9) die Abziehvorrichtung (7) von der Haltegreifer (6) Richtung Spanngreifer (11) bewegt und dadurch ein Wärmeleitpad (1) von der, zwischen Haltegreifer (6) und Spanngreifer (11) gespannten und durch die Abziehvorrichtung (7) z-förmig umgelenkten, Trägerfolie (2) löst.

11. Verfahren nach einem der Ansprüche 8 bis 10, **dadurch gekennzeichnet,**
- **dass** das Wärmeleitpad (1) beim Ablösen von der Trägerfolie (2) von einem Abnahmegreifer (14) gehalten wird,
- insbesondere dass der Abnahmegreifer (14) eine an ein Sauggebläse (15) angeschlossene Saugplatte mit einer Abnahmefläche (17) und mit, in der Abnahmefläche (17) vorgesehenen, Saugöffnungen (18) umfasst.

12. Verfahren nach einem der Ansprüche 8 bis 11, **dadurch gekennzeichnet,**
- **dass** ein Blatt bzw. ein Bogen einer Trägerfolie (2) mit mindestens einem Wärmeleitpad (1), bevorzugt mit mehreren Wärmeleitpads (1), von einer Einlegevorrichtung (19) eingelegt wird,
- und/oder dass ein Blatt bzw. ein Bogen einer Trägerfolie (2) mit mindestens einem Wärmeleitpad (1), bevorzugt mit mehreren Wärmeleitpads (1), von einer Positioniervorrichtung (20) exakt positioniert und ausgerichtet wird.

13. Verfahren nach einem der Ansprüche 8 bis 12, **dadurch gekennzeichnet, dass** ein Bereich der Trägerfolie (2) in den geöffneten Haltegreifer (6) und gegebenenfalls ein anderer Bereich der Trägerfolie (2) in den geöffneten Spanngreifer (11) von einer Einführvorrichtung (21) eingeführt wird oder werden.

## Claims

1. A device for automatically peeling a thermally conductive pad (1) from the front side (3) of a flexible carrier film (2), comprising:
- a tensioning device (5) with an openable and closable holding gripper (6) for gripping and holding the carrier film (2),
- a stripping device (7) having a stripping edge (8) for deflecting the carrier film (2) around its rear side (4),
- and a stripping drive (9) which increases the distance (10) between the stripping edge (8) and the holding gripper (6) and is designed to move the carrier film (2) over the stripping edge (8) and thereby strip the carrier film (2) from the thermally conductive pad (1),
**characterized**
- **in that** the tensioning device (5) comprises, in addition to the holding gripper (6), a **tensioning gripper** (11) and a tensioning drive (12),
- **in that** the holding gripper (6) and the tensioning gripper (11) are designed to hold a carrier film (2) with thermally conductive pads (1) in different and opposing sections,
- and **in that** the tensioning drive (12) is designed to tension the carrier film (2) between the holding gripper (6) and the tensioning gripper (11).

2. The device according to claim 1, **characterized**
- **in that** the stripping device (7) has, in addition to the stripping edge (8), a deflection strip (13),
- and **in that** the stripping device (7) is designed to deflect the carrier film (2) in a Z-shaped path.

3. The device according to any one of claims 1 or 2, **characterized**
- **in that** the stripping drive (9) moves the stripping device (7) away from the holding gripper (6) and is designed to peel a thermally conductive pad (1) from the carrier film (2) tensioned between the holding gripper (6) and the stripping device (11) and deflected by the stripping device (11) in a Z-shaped path,
- or in that the stripping drive (9) moves the stripping device (7) from the holding gripper (6) towards the tensioning gripper (11) and is designed to peel a thermally conductive pad (1) from the carrier film (2) tensioned between the holding gripper (6) and the tensioning gripper (11) and deflected by the stripping device (11) in a Z-shaped path.

4. The device according to any one of claims 1 to 3, **characterized**
- **in that** a **removal gripper** (14) for holding the thermally conductive pad (1) while being peeled from the carrier film (2) is provided,
- in particular, in that the removal gripper (14) comprises a suction plate connected to an exhaust fan (15) with a removal face (17) and suction apertures (18) provided in the removal face (17).

5. The device according to any one of claims 1 to 4, **characterized**
- **in that** a deposition device (19) for depositing a carrier film (2) sheet or web carrying at least one thermally conductive pad (1), preferably a plurality of thermally conductive pads (1), is provided,
- and/or in that a **positioning device** (20) for accurately positioning and orienting a carrier film (2) sheet or web carrying at least one thermally conductive pad (1), preferably a plurality of thermally conductive pads (1), is provided.

6. The device according to any one of claims 1 to 5, **characterized in that** an **insertion device** (21)with at least one insertion element (22) for inserting a section of the carrier film (2) into the open holding gripper (6) and optionally inserting another section of the carrier film (2) into the open tensioning gripper (11) is provided.

7. An **arrangement** of a flexible **carrier film** (2) provided with at least one thermally conductive pad (1) on its front side, and an assembly of a **device according to any one of the preceding claims,** comprising:
- a tensioning device (5) with an openable and closable holding gripper (6) which grips and holds the carrier film (2),
- a stripping device (7) having a stripping edge (8) along which the carrier film (2) is deflected around its rear side (4),
- and a stripping drive (9) which increases the distance (10) between the stripping edge (8) and the holding gripper (6), thereby moving the carrier film (2) over the stripping edge (8) and stripping the carrier film (2) from the thermally conductive pad (1).

8. A **method** for automatically peeling a thermally conductive pad (1)from the front side (3) of a flexible carrier film (2), comprising the following steps of:
- gripping and holding the carrier film (2) with a holding gripper (6) of a tensioning device (5),
- deflecting the carrier film (2) with its rear side (4) along a stripping edge (8) of a stripping device (7),
- increasing the distance (10) between the stripping edge (8) and the holding gripper (6) by a stripping drive (9), thereby moving the carrier film (2) over the stripping edge (8) and stripping the carrier film (2) from the thermally conductive pad (1),
**characterized**
- **in that** the carrier film (2) with thermally conductive pads (1) is held by a holding gripper (6) and a tensioning gripper (11) in different and opposing sections,
- and **in that** the carrier film (1) is tensioned between the holding gripper (6) and the tensioning gripper (11) by actuating a tensioning drive (12).

9. The method according to claim 8, **characterized in that** the carrier film (2) is deflected over the stripping edge (8) and a deflection strip (13) of the stripping device (7) in a Z-shaped path.

10. The method according to any one of claims 8 or 9, **characterized**
- **in that** the stripping drive (9) moves the stripping device (7) away from the holding gripper (6) and peels a thermally conductive pad (1) from the carrier film (2) tensioned between the holding gripper (6) and the stripping device (7) and deflected by the stripping device (7) in a Z-shaped path,
- or in that the stripping drive (9) moves the stripping device (7) from the holding gripper (6) towards the tensioning gripper (11) and thereby peels a thermally conductive pad (1) from the carrier film (2) tensioned between the holding gripper (6) and the tensioning gripper (11) and deflected by the stripping device (7) in a Z-shaped path.

11. The method according to any one of claims 8 to 10, **characterized**
- **in that**, while being peeled from the carrier film (2), the thermally conductive pad (1) is held by a removal gripper (14),
- in particular, in that the removal gripper (14) comprises a suction plate connected to an exhaust fan (15) with a removal face (17) and suction apertures (18) provided in the removal face (17).

12. The method according to any one of claims 8 to 11, **characterized**
- **in that** a carrier film (2) sheet or web carrying at least one thermally conductive pad (1), preferably a plurality of thermally conductive pads (1), is deposited by a deposition device (19),
- and/or in that a carrier film (2) sheet or web carrying at least one thermally conductive pad (1), preferably a plurality of thermally conductive pads (1), is accurately positioned and oriented by a positioning device (20).

13. The method according to any one of claims 8 to 12, **characterized in that** a section of the carrier film (2) is inserted into the open holding gripper (6) and optionally another section of the carrier film (2) is inserted into the open tensioning gripper (11) by an insertion device (21).

## Revendications

1. **Dispositif** destiné au détachement automatisé d'un tampon thermoconducteur (1) de la face avant (3) d'une feuille de support (2) flexible, comprenant :
- un dispositif de serrage (5) comportant une pince de maintien (6) ouvrable et fermable, destinée à saisir et à maintenir la feuille de support (2),
- un dispositif de décollement (7) comportant un bord de décollement (8), destiné à dévier la feuille de support par sa face arrière (4),
- et un entraînement de décollement (9) qui augmente la distance (10) entre le bord de décollement (8) et la pince de maintien (6), et qui est conçu pour déplacer la feuille de support (2) sur le bord de décollement (8) et ainsi décoller la feuille de support (2) du tampon thermoconducteur (1),
**caractérisé**
- **en ce que** le dispositif de serrage (5) comprend, outre la pince de maintien (6), une **pince de serrage** (11) et un entraînement de serrage (12),
- **en ce que** la pince de maintien (6) et la pince de serrage (11) sont conçues pour maintenir une feuille de support (2) comportant des tampons thermoconducteurs (1) dans des zones différentes ou opposées,
- et **en ce que** l'entraînement de serrage (12) est conçu pour serrer la feuille de support (2) entre la pince de maintien (6) et la pince de serrage (11).

2. Dispositif selon la revendication 1, **caractérisé**
- **en ce que** le dispositif de décollement (7) comporte, outre le bord de décollement (8), une barre de déviation (13),
- et **en ce que** le dispositif de décollement (7) est conçu pour dévier la feuille de support (2) en forme de Z.

3. Dispositif selon l'une des revendications 1 ou 2, **caractérisé**
- **en ce que** l'entraînement de décollement (9) éloigne le dispositif de décollement (7) de la pince de maintien (6) et est conçu pour détacher un tampon thermoconducteur (1) de la feuille de support (2) serrée entre la pince de maintien (6) et le dispositif de décollement (11) et déviée en forme de Z par le dispositif de décollement (7)
- ou en ce que l'entraînement de décollement (9) déplace le dispositif de décollement (7) de la pince de maintien (6) vers la pince de serrage (11), et est conçu pour détacher un tampon thermoconducteur (1) de la feuille de support (2) serrée entre la pince de maintien (6) et la pince de serrage (11) et déviée en forme de Z par le dispositif de décollement (7).

4. Dispositif selon l'une des revendications 1 à 3, **caractérisé**
- **en ce qu'**une pince de prélèvement (14) est prévue pour maintenir le tampon thermoconducteur (1) pendant son détachement de la feuille de support (2),
- en particulier en ce que la pince de prélèvement (14) comprend une plaque d'aspiration raccordée à un ventilateur d'aspiration (15), comportant une surface de prélèvement (17) et des orifices d'aspiration (18) prévus dans la surface de prélèvement (17).

5. Dispositif selon l'une des revendications 1 à 4, **caractérisé**
- **en ce qu'**un dispositif d'insertion (19) est prévu pour insérer une feuille ou une bande d'une feuille de support (2) comportant au moins un tampon thermoconducteur (1), de préférence plusieurs tampons thermoconducteurs (1),
- et/ou en ce qu'un dispositif de positionnement (20) est prévu pour le positionnement et l'alignement précis d'une feuille ou d'une bande d'une feuille de support (2) comportant au moins un tampon thermoconducteur (1), de préférence plusieurs tampons thermoconducteurs (1).

6. Dispositif selon l'une des revendications 1 à 5, **caractérisé en ce qu'**un **dispositif d'introduction** (21) est prévu, comportant au moins un élément d'introduction (22) destiné à introduire une partie de la feuille de support (2) dans la pince de maintien (6) ouverte et, optionnellement, une autre partie de la feuille de support (2) dans la pince de serrage (11) ouverte.

7. **Agencement** d'une **feuille de support (2)** flexible, sur la face avant de laquelle est prévu au moins un **tampon thermoconducteur (1),** et **dispositif selon l'une des revendications précédentes,** comprenant :
- un dispositif de serrage (5) comportant une pince de maintien (6) ouvrable et fermable, qui saisit et maintient la feuille de support (2),
- un dispositif de décollement (7) comportant un bord de décollement (8) autour duquel la feuille de support (2) est déviée autour de sa face arrière (4),
- et un entraînement de décollement (9) qui augmente la distance (10) entre le bord de décollement (8) et la pince de maintien (6), ce qui permet de déplacer la feuille de support (2) sur le bord de décollement (8) et de la décoller du tampon thermoconducteur (1).

8. **Procédé** de détachement automatisé d'un tampon thermoconducteur (1) de la face avant (3) d'une feuille de support (2) flexible, comprenant les étapes suivantes :
- saisir et maintenir la feuille de support (2) à l'aide d'une pince de maintien (6) d'un dispositif de serrage (5),
- dévier la feuille de support (2) par sa face arrière (4) autour d'un bord de décollement (8) d'un dispositif de décollement (7),
- augmenter la distance (10) entre le bord de décollement (8) et la pince de maintien (6) à l'aide d'un entraînement de décollement (9), ce qui permet de déplacer la feuille de support (2) sur le bord de décollement (8) et de la décoller du tampon thermoconducteur (1),
- **caractérisé**
- **en ce que** la feuille de support (2) comportant des tampons thermoconducteurs (1) est maintenue, dans des zones différentes ou opposées, par une pince de maintien (6) et une pince de serrage (11),
- et **en ce que** la feuille de support (2) est serrée entre la pince de maintien (6) et la pince de serrage (11) par l'actionnement d'un entraînement de serrage (12).

9. Procédé selon la revendication 8, **caractérisé en ce que** la feuille de support (2) est déviée en forme de Z autour du bord de décollement (8) et d'une barre de déviation (13) du dispositif de décollement (7).

10. Procédé selon l'une des revendications 8 ou 9, **caractérisé**
- **en ce que** l'entraînement de décollement (9) éloigne le dispositif de décollement (7) de la pince de maintien (6) et détache un tampon thermoconducteur (1) de la feuille de support (2) serrée entre la pince de maintien (6) et le dispositif de décollement (7) et déviée en forme de Z par le dispositif de décollement (7),
- ou en ce que l'entraînement de décollement (9) déplace le dispositif de décollement (7) de la pince de maintien (6) vers la pince de serrage (11), détachant ainsi un tampon thermoconducteur (1) de la feuille de support (2) serrée entre la pince de maintien (6) et la pince de serrage (11) et déviée en forme de Z par le dispositif de décollement (7).

11. Procédé selon l'une des revendications 8 à 10, **caractérisé**
- **en ce que** le tampon thermoconducteur (1) est maintenu par une pince de prélèvement (14) lors de son détachement de la feuille de support (2),
- en particulier en ce que la pince de prélèvement (14) comprend une plaque d'aspiration raccordée à un ventilateur d'aspiration (15), comportant une surface de prélèvement (17) et des orifices d'aspiration (18) prévus dans la surface de prélèvement (17).

12. Procédé selon l'une des revendications 8 à 11, **caractérisé**
- **en ce qu'**une feuille ou une bande d'une feuille de support (2), comportant au moins un tampon thermoconducteur (1), de préférence plusieurs tampons thermoconducteurs (1), est insérée par un dispositif d'insertion (19),
- et/ou en ce qu'une feuille ou une bande d'une feuille de support (2), comportant au moins un tampon thermoconducteur (1), de préférence plusieurs tampons thermoconducteurs (1), soit positionnée et alignée précisément par un dispositif de positionnement (20).

13. Procédé selon l'une des revendications 8 à 12, **caractérisé en ce qu'**une partie de la feuille de support (2) est introduite dans la pince de maintien (6) ouverte et, optionnellement, une autre partie de la feuille de support (2) est introduite dans la pince de serrage (11) ouverte par un dispositif d'introduction (21).
